# EUROPEAN PATENT APPLICATION

(11) **EP 2 420 826 A1**
(43) Date of publication of application: **22.02.2012**
(21) Application number: 10173134.7
(22) Date of filing: 17.08.2010
(51) Int. Cl.: G01N 27/22

(54) **Integrated Circuit and Manufacturing Method Therefor**

(71) Applicant: NXP B.V., 5656 AG Eindhoven (NL)
(72) Inventor: Daamen, Roel, Redhill, Surrey RH1 1DL (GB); Jeurissen, Dennis, Redhill, Surrey RH1 1DL (GB)
(74) Representative: Burton, Nick

(57) **Abstract**

Disclosed is an integrated circuit (200) comprising a substrate (10) including a plurality of circuit elements and a metallization stack (20) covering said substrate for providing interconnections between the circuit elements, wherein the top of said stack is protected by a passivation layer stack (30), the integrated circuit further comprising a moisture sensor (210) comprising a first electrode (50) and a second electrode (60) separated from the first electrode by an electrically insulating moisture-absorbing material (40), wherein at least one of said first electrode and second electrode is located above the passivation layer stack. An IC package comprising such an IC, an electronic device comprising such a package and a method of manufacturing such an IC are also disclosed.

## Description

### FIELD OF THE INVENTION

The present invention relates to an integrated circuit (IC) comprising a substrate including a plurality of circuit elements and a metallization stack covering said substrate for providing interconnections between the circuit elements.

The present invention further relates to a method of manufacturing such an IC.

### BACKGROUND OF THE INVENTION

Nowadays, integrated circuits (ICs) routinely comprise patterned metallization layers for interconnecting circuit elements, e.g. transistor terminals in the substrate or to provide external access, e.g. bond pads, to the circuit elements that are embedded in the semiconductor device. Typically, the metallization layers are formed by stacking and patterning dielectric layers and metal layers to obtain the required interconnections. The dielectric and metal layers themselves may contain sub-layers. The dielectric layers typically comprise vias to conductively connect metal portions in the different metal layers with each other.

Rigorous testing of the ICs, e.g. when they are still part of a wafer, takes place to ensure that the IC operates correctly, e.g. is free of manufacturing defects. This is important because the IC may be integrated into an electronic device, where the failure of the IC in the electronic device would most likely cause the electronic device to exhibit faulty behavior. For this reason, significant efforts are made to ensure that defective ICs are removed from a batch of manufactured ICs to avoid field returns of electronic devices containing such ICs as much as possible. Field returns inconvenience the customer, and can lead to a loss of business because of the customer losing faith in the product. Nevertheless, it is very difficult to capture all defective ICs such that it cannot be avoided that some defective ICs enter the market, e.g. inside an electronic device. On the other hand, a returned faulty electronic device may have entered the market functioning correctly, where it is possible that the fault has developed through misuse of the semiconductor device, e.g. by the customer accidentally submerging the device in water. Obviously, in such a case, the manufacturer cannot be held responsible for the failure of the device.

It is difficult to establish why a semiconductor device returned from the field has failed. Re-engineering the device to determine the cause of failure is not always successful and is cost-prohibitive for single devices.

US 4,057,823 discloses a structure for a relative humidity monitor which can be built into an integrated circuit chip. A small area on a silicon chip is made porous by anodic etching. This region is then oxidized and a metal counter electrode is deposited over part of the porous area. Due to the relatively large surface area in the dielectric under the counter electrode and the openness of the structure, ambient moisture can quickly diffuse into the dielectric under the electrode and adsorb onto the silicon dioxide surface, such that changes in ambient humidity will be reflected by measurable changes in capacitance or conductance of the device.

Such a sensor however suffers from a number of drawbacks. For instance, moisture penetrating into the structure can cause sensor drift and even device failure in a worst case scenario, for instance direct contact with water is likely to cause a device failure as the IC active circuits are likely to fail upon such exposure.

### SUMMARY OF THE INVENTION

The present invention seeks to provide an IC in which at least some of the aforementioned problems can be alleviated.

The present invention further seeks to provide a method of manufacturing such an IC.

In accordance with a first aspect of the present invention, there is provided an integrated circuit comprising a substrate including a plurality of circuit elements and a metallization stack covering said substrate for providing interconnections between the circuit elements, wherein the top of said stack is protected by a passivation layer stack, the integrated circuit further comprising a moisture sensor comprising a first electrode and a second electrode separated from the first electrode by an electrically insulating moisture-absorbing material, wherein at least one of said first electrode and second electrode is located above the passivation layer stack.

Hence, it has been recognized that the moisture sensor, e.g. a relative humidity sensor, may be formed on the external side of the passivation layer stack, such that the passivation layer stack protects the underlying circuit elements from moisture exposure such that exposure of the IC to moisture can be detected in a more robust manner. In addition, because an electrically insulating moisture-absorbing material is used, monitoring of a change in the dielectric properties of the electrically insulating materials may be postponed, i.e., constant monitoring is no longer necessary.

In a preferred embodiment, said moisture-absorbing material forms at least a part of a re-passivation or a re-distribution layer over the passivation layer stack. This has the advantage that no additional processing steps need to be performed to deposit the moisture-absorbing material. As will be known to the skilled person, the re-passivation and re-distribution layers are used to reroute the bond pads and alleviate stress in the device or package including the device, e.g. caused by temperature changes, which prevent the passivation layer stack from cracking and/or prevent die delamination.

It has recognized that certain polymer materials that are used for re-passivation or re-distribution layers are capable of retaining moisture. In a preferred embodiment, the moisture-absorbing material is polyimide as polyimide is a class A material, which means that has a small expansion coefficient and therefore introduces little stress in a package including the IC of the present invention. Polyimide is a material having modest moisture-absorbing properties, although it is believed that other polymers capable of forming hydrogen bonds with water may also be suitable. It is further noted that it has been found that polyimides have modest moisture-retention properties, i.e. show hysteresis towards water absorption. In the context of the present invention, a moisture-retaining material is a material showing hysteresis towards the amount of moisture, e.g. water, in the environment to which the material is exposed.

The electrodes of the capacitive moisture sensor formed on top of the passivation layer stack of the IC of the present invention may be formed as plate electrodes. Alternatively, the first and second electrodes may be meandering electrodes arranged relative to each other in an interdigitated fashion. This for instance has the advantage that the sensitivity of the sensor can be easily tuned by variation of the spacing between the interdigitated electrodes. In other words, in this embodiment, an in-plane meander-comb or finger sensor is provided.

In an embodiment, at least one of the first electrode and second electrode is electrically connected to an externally accessible bond pad. The first and/or second electrode may alternatively be electrically connected to at least one of said circuit elements through said metal portion.

The IC of the present invention may be included in an integrated circuit package, wherein the package comprises a cavity exposing the electrically insulating moisture-absorbing material, such that exposure to excess moisture levels can be more easily detected. Such a cavity may for instance be formed through a molded cover layer of the package, which has the advantage that the cavity can be formed in an inexpensive and straightforward manner.

The IC or IC package may be advantageously integrated into an electronic device to allow the detection of the exposure of the electronic device to moisture, particularly water. In the context of the present application, the term electronic device is intended to cover any device or apparatus that can receive the IC of the present invention, including consumer electronic devices such as mobile communication devices, (laptop) computers as well as medical devices, automotive devices and so on.

In accordance with another aspect of the present invention, there is provided a method of manufacturing an integrated circuit comprising providing a substrate comprising a plurality of circuit elements on said substrate and a metallization stack covering said substrate for providing interconnections between the circuit elements; depositing a passivation layer stack of said metallization stack; forming a moisture sensor over said passivation layer stack by providing a first electrode; providing a second electrode; and depositing an electrically insulating moisture-absorbing material such that the first electrode and the second electrode are separated by the electrically insulating moisture-absorbing material.

This method facilitates the manufacture of a capacitive moisture sensor on top of the passivation layer stack, e.g. passivation stack, of an IC which is fully compatible with existing manufacturing processes, e.g. CMOS processes, and requires only a few additional processing steps such that the moisture sensor may be provided on top of the IC at little additional cost.

Preferably, the step of depositing the electrically insulating moisture-absorbing material is comprised in a step of depositing a re-passivation or a re-distribution layer over the passivation layer stack for reasons already disclosed above.

In an embodiment, the step of providing the first electrode comprises forming a first meandering electrode on the electrically insulating moisture-absorbing material, said first meandering electrode being electrically connected to the metal portion, the step of forming the second electrode comprises forming a second meandering electrode on the electrically insulating moisture-absorbing material, said second meandering electrode being spatially separated from the first meandering electrode and being arranged respective to the first meandering electrode in an interdigitated manner; and wherein the method further comprises filling the gap between the first meandering electrode and the second meandering electrode with the electrically insulating moisture-absorbing material.

As previously explained, this has the advantage of obtaining in-plane electrodes having a relatively large surface area, which improves the sensitivity of the moisture sensor in the IC of the present invention.

### BRIEF DESCRIPTION OF THE EMBODIMENTS

Embodiments of the invention are described in more detail and by way of non-limiting examples with reference to the accompanying drawings, wherein
FIG. 1 schematically depicts a typical IC design;
FIG. 2 shows a photographic image of a detail of a specific IC design;
FIG. 3 schematically depicts an aspect of a typical IC design;
FIG. 4 schematically depicts another aspect of a typical IC design;
FIG. 5 schematically depicts the principle of the moisture sensor of the present invention;
FIG. 6 schematically depicts an embodiment of an IC of the present invention;
FIG. 7 schematically depicts another embodiment of an IC of the present invention;
FIG. 8 schematically depicts yet another embodiment of an IC of the present invention;
FIG. 9 schematically depicts an alternative embodiment of an IC of the present invention;
FIG. 10 schematically depicts an alternative view of the embodiment shown in FIG. 9;
FIG. 11-14 schematically depict further alternative embodiments of an IC of the present invention; and
FIG. 15 schematically depicts an embodiment of an IC package of the present invention.

### DETAILED DESCRIPTION OF THE DRAWINGS

It should be understood that the Figures are merely schematic and are not drawn to scale. It should also be understood that the same reference numerals are used throughout the Figures to indicate the same or similar parts.

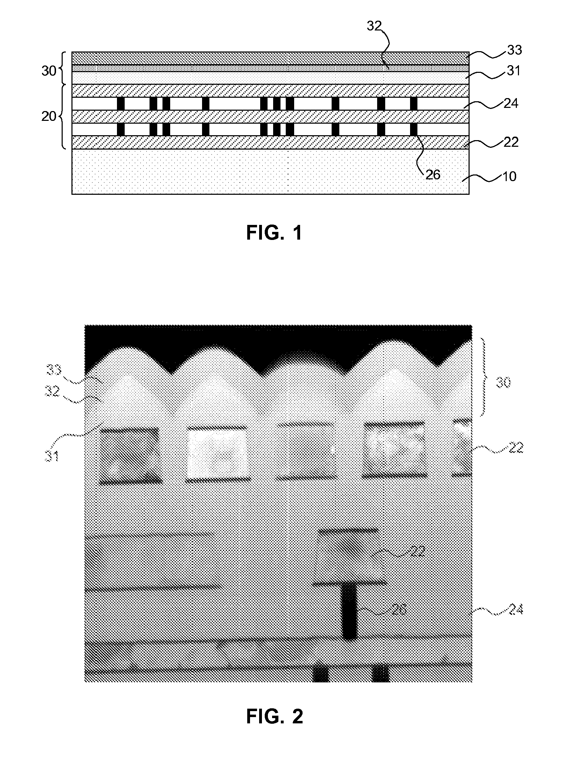

FIG. 1 schematically depicts an IC in accordance with an embodiment of the present invention. The IC of the present invention may be provided using any suitable manufacturing technology, such as CMOS, silicon-on-insulator and SiGe technologies. The IC comprises a substrate 10, e.g. a Si substrate, a SiGe substrate and so on, which typically comprises a plurality of circuit elements such as transistors, diodes, and so on, combinations of which from circuits. These may be analog or digital circuits. It should be understood that the present invention is not limited to specific types of ICs. The present invention may be included in any suitable IC, including digital ICs, analog ICs and mixed signal ICs.

The interconnections between the circuit elements in the substrate 10 to define the circuits are typically provided by a metallization stack 20, which by way of non limiting example may comprise a plurality of patterned metal layers 22 separated by dielectric layers 24. Any suitable number of metal layers 12 and dielectric layers 14 may be present. In an embodiment, the metallization stack 20 may comprise a single metal layer and a single dielectric layer separating portions of the patterned single metal layer from the underlying circuitry.

Metal portions in different metal layers 22 may be conductively interconnected by one or more vias 26 formed in a dielectric layer 24 in between the respective portions of the metal layers 22. Any suitable material may be used to form the metallization stack 20, such as Ti, TiN, Al, Cu and combinations thereof to define the metal layers 22 and silicon oxide, silicon nitride, low-k dielectrics and other dielectric materials as well as combinations thereof to form the dielectric layers 24. Although in FIG. 1 these layers are depicted as single layers, it should be understood that these layers themselves may comprise a stack of layers, as is common design practice in contemporary semiconductor technologies such as sub-micron CMOS technologies. It should be understood that the substrate 10 and the metallization stack 20 have no bearing on the present invention and may therefore adopt any suitable embodiment.

The metallization stack 20 is typically covered by a passivation stack 30 that protects the IC from its environment, in particular dust and moisture. The passivation stack 30 may adopt any suitable form. For instance, in CMOS process technology, a multi-layer passivation stack 30 may include, from bottom to top, a high density plasma (HDP) oxide layer 31, a thin silicon-rich oxide layer 32 and a silicon nitride layer 33. FIG. 2 shows a photograph taken of a cross section of such an IC comprising a passivation layer stack 30. The silicon nitride layer typically is the top layer as it is a hard material that provides excellent scratch protection, thereby protecting the IC against scratching in further processing, e.g. packaging.

Alternative embodiments of passivation stacks 30 used in CMOS process technology include double layer arrangements consisting of a silicon-rich oxide layer or a HDP oxide with silicon nitride, or multi-layer arrangements including SACVD oxide, a thin tetraethyl-orthosilicate (TEOS) layer, phosphor-doped silicon glass and silicon nitride on top. In general, smaller feature size technologies such as sub-micron CMOS technologies employ fewer layers in the passivation stack 30 compared to larger scale technologies. The passivation layer 30 is typically opened up, e.g. by etching, to provide access to the bond pads, i.e. metal portions in the top metallization layer of the IC. This is not explicitly shown.

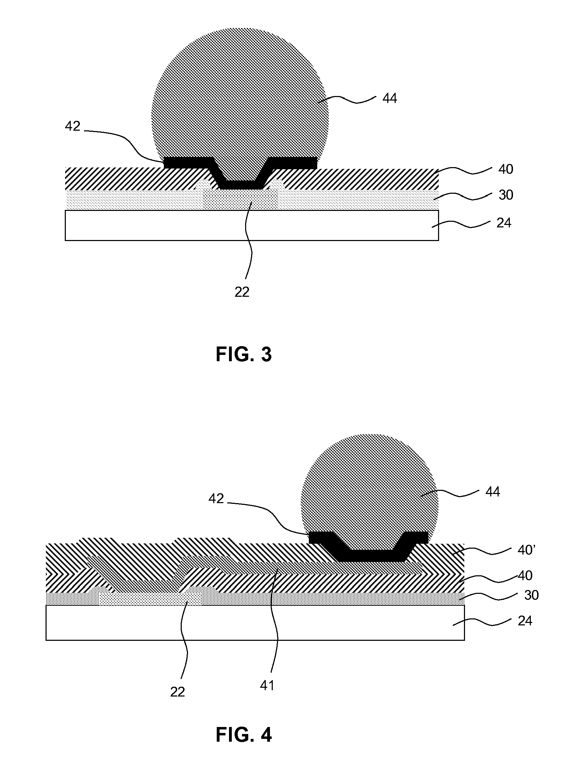

In preparation of the IC for packaging, a re-passivation layer may be deposited on top of the passivation layer stack 30. This is shown in FIG. 3. The re-passivation layer 40 facilitates the formation of metal structures such as an under-bump metallization portion 42 thereon, such that a larger external connection such as a bump pad or solder bump 44 may be formed on the outside of the IC. This process is also known as fan-out. In addition to the purpose of facilitating the increase of the feature size of the external contacts of the IC, the re-passivation layer 40 also serves to reduce stress between the IC and its package due to a certain degree of flexibility in the re-passivation layer 40. Suitable materials for the re-passivation layer 40 are well-known to the skilled person and include polymers such as polyimide, which may be applied as a single layer or as part of a bump-on-active (BUMA) structure. A suitable polyimide is the photo-definable polyimide with the trade name PI-8124-ER supplied by the Asahi Company. Other polyimides have been reported in the literature to exhibit moisture-absorbing properties.

Alternatively, stress reduction and fan-out may be provided by means of a redistribution layer, which is shown in FIG. 4. Redistribution layers are used to laterally displace an external bond pad such a bump pad 44 with respect to the stack metal portion 22 in the patterned top metal layer of the metallization stack 20. To this end, a metal track 41 may be formed on the re-passivation layer 40, after which the metal track 41 may be covered by a further re-passivation layer 40', e.g. another polyimide layer, which is subsequently patterned to provide access to the metal track 41 for formation of the under-bump metallization 42 and bump pad 44. The re-passivation layers 40 and/or 40' may be applied as a coating over the entire wafer instead of application of individual chip coatings, which has the advantage of a simplified (single step) and more cost-effective coating process, e.g. by means of spin-coating the wafer with polyimide or another resin, as well as improved process control as there is significantly reduced inter-die variation caused by different quality coatings.

It has been recognized by the present inventors that some of the insulating materials used for the formation of re-passivation and redistribution layers have modest moisture absorbing properties. In particular, polyimide has been demonstrated to adsorb small amounts of moisture. Another example of a suitable class of polymers with moisture-absorbing properties is benzocyclobutenes. Without wishing to the bound by theory, it is assumed that in case of polyimide, the imide functional groups in polyimide form strong hydrogen bonds with the adsorbed moisture, thereby preventing the moisture from readily escaping the polymer material. For this reason, it is believed that polymers other than polyimide that can be used as of re-passivation and redistribution layers and that are capable of forming hydrogen bonds with e.g. water are also suitable materials.

These surprising moisture-absorbing properties of polymer materials such as polyimide in combination with their suitability of forming metal structures thereon have been utilized to provide a moisture sensor such as a relative humidity sensor that is at least partially located in the re-passivation and redistribution layers. This has the advantage that the passivation layer protecting the active circuitry of the IC is not compromised such that even when being exposed to excessive amounts of moisture, e.g. during an immersion event, the IC of the present invention has an improved probability of remaining operational, which can be a very important benefit in application domains where device failure should be avoided at all times, e.g. automotive applications. It is important to note that as such polymers, and in particular polyimide have modest liquid uptake properties only, the underlying passivation stack 30 and active circuitry underneath the passivation stack 30 is unlikely to be exposed to excessive moisture levels.

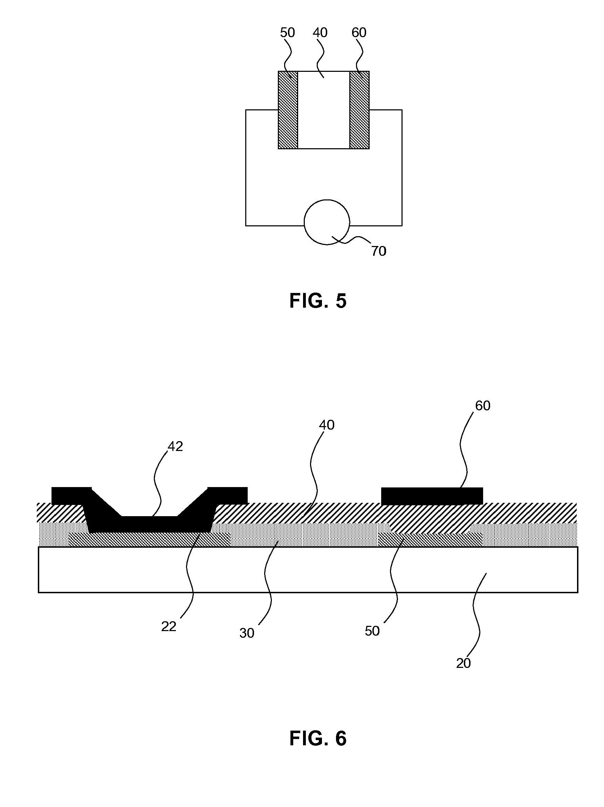

The principle of moisture sensor formed on top of the passivation layer 30 in the IC of the present invention will be explained in more detail with the aid of FIG. 5. Neighboring electrodes 50 and 60 are separated by a dielectric medium formed by the moisture-absorbing re-passivation or redistribution layer material 40, e.g. polyimide. The electrodes 50, 60 may be connected to a measurement circuit 70 through the metallization stack 20 in case of the measurement circuit 70 being formed by a selection of circuit elements on the substrate 10, through external bond pads, e.g. respective bump pads 44 in case of the measurement circuit 70 being external to the IC or a combination thereof. An impedance measurement across the portion of the liquid retention layer 40 in between the electrodes 50 and 60 can be performed to determine the relative humidity of the environment in which the IC is placed. Alternatively, such a measurement could also be used to determined if the IC has been exposed to excessive humidity levels, e.g. has been immersed in water.

In FIG. 5, an arrangement is shown in which the liquid immersion sensor comprises a capacitor, with the electrodes 50 and 60 forming the plates of the capacitor and the portion of the moisture-absorbing material 40 or 40' forming the dielectric separating the capacitor plates. Since the capacitance C of the capacitor is defined as C = ε.A/d, with ε being the electric permittivity (or dielectric constant) of the moisture-absorbing material 40 or 40', A being the area of the capacitor plates (i.e. the electrodes 50 and 60) and being the distance between the capacitor plates (i.e. the thickness of the portion of the of the liquid retention layer 40 in between the electrodes 50 and 60), any change in the permittivity of the moisture-absorbing material 40 causes a corresponding change in the capacitance of the aforementioned capacitor, thus enabling the detection of the exposure of the moisture-absorbing material 40 to (excess) moisture.

The read-out of the (relative humidity) sensor may be realized in any suitable manner. For instance, the capacitance increase of a capacitor-based liquid immersion sensor may be detected by using a differential measurement in which its capacitance is compared with the capacitance of a reference capacitor that has the same initial capacitance as the (relative humidity) sensor and which is not sensitive to variations in the moisture levels to which the IC is exposed, e.g. by using a reference capacitor in the lower metal layers 22 of the metallization stack 20, which is protected from moisture exposure by the passivation stack 30.

FIG. 6 depicts a cross-section of a first embodiment of an IC of the present invention comprising a moisture sensor in the re-passivation layer 40. The moisture sensor is formed by a metal portion acting as a first electrode 50 in the top metal layer of the metallization stack 20, which may further comprise bond pads 22 for connecting to external contacts, e.g. through under-bump metallization (UBM) 42. The passivation stack 30 is typically opened, e.g. by an etching step, thereby exposing the bond pads 22 and first electrode 50. In other words, a number of recesses are formed in the passivation stack 30 to expose these underlying metal structures. It is well-known to the skilled person how to open a passivation stack 30 so this will not be further explained for reasons of brevity.

The re-passivation layer 40 may be deposited in any suitable manner, e.g. by spin-coating in case of a polymer such as polyimide, after which the polyimide is patterned to provide access to the bond pads 22. It is noted that the recess over the first electrode is not reopened as the passivation layer portion over the first electrode 50 will act as the dielectric material of the plate capacitor to be formed. Next, the UBM 42 and a second electrode 60 are formed on the re-passivation layer 40, with the second electrode 60 formed over the first electrode 50, such that the sandwich formed by the second electrode 60, re-passivation layer 40 and first electrode 50 defines a plate capacitor. The first electrode 50 and the second electrode 60 may be connected to active circuitry (not shown) underneath the passivation layer 30. The connections to the second electrode 60 are not shown for reasons of clarity only. The electrodes 50 and 60 may be formed of any suitable conductive material, e.g. metals such as copper, aluminium, tungsten, suitable metal alloys and so on.

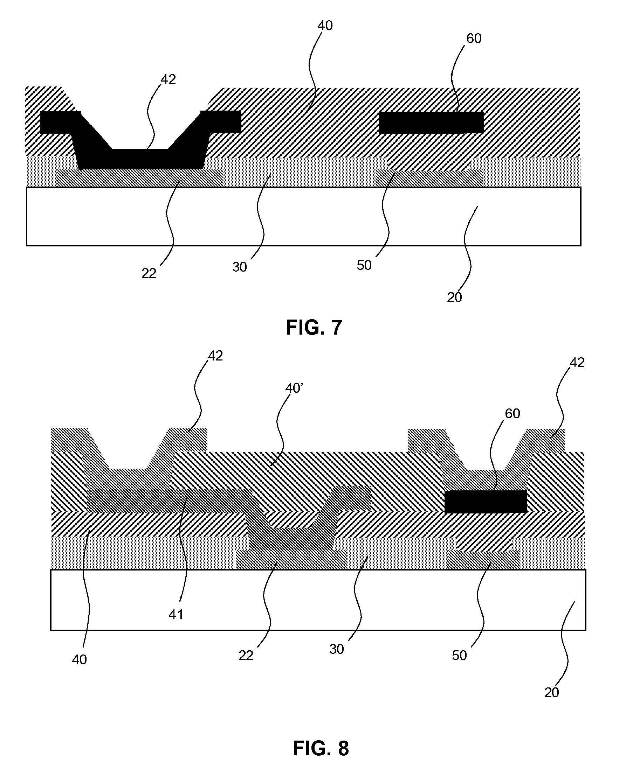

The top of the second electrode 60 may be further protected by embedding it in another layer of the re-passivation layer 40, as shown in the cross-section depicted in FIG. 7. This further layer alternatively may form part of a redistribution layer 40', which function has been explained with the aid of FIG. 4.

FIG. 8 depicts a cross-section of an embodiment of the IC of the present invention in which the redistribution layer 40' is opened up above the second electrode 60 to facilitate connection of the second electrode 60 to an external contact such as a bump pad, e.g. via UBM 42. In this embodiment, the external contact to the bond pad 22 may be laterally displaced by means of conductive track 41 as previously explained.

In the previous embodiments, the moisture sensor has been designed as a stacked capacitor with the second electrode 60 located above the first electrode 50. Typically, the first electrode is formed in the top metallization layer of the metallization stack 20. However, other spatial arrangements are equally feasible. For instance, the electrodes 50 and 60 do not have to be shaped as plates, and may for instance be located in the same horizontal plane of the IC.

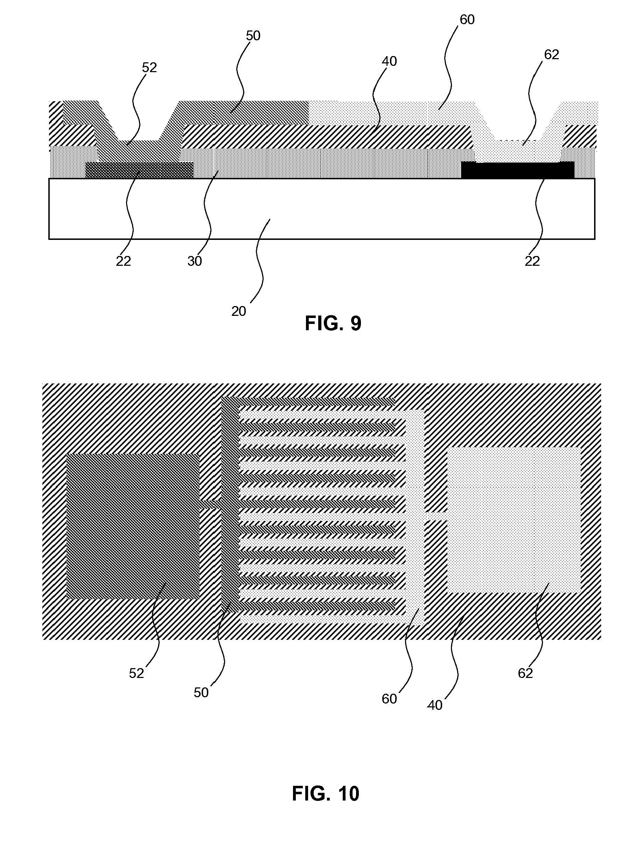

In an embodiment, the electrodes 50 and 60 are formed as finger electrodes in the same horizontal plane of the IC, with the electrode fingers being interdigitated. A cross-section of such a device is shown in FIG. 9, whilst a top view is shown in FIG. 10. The finger electrodes 50 and 60 are mounted on respective metal portions 22 of the top metallization layer of the metallization stack 20 through passivation layer 30, and may be provided with respective bond pads 52 and 62 to facilitate the electrodes being externally accessible, e.g. through a solder bump or bump pad (not shown) on the bond pads 52 and 62. In case of the electrodes 50, 60 being connected to active circuitry inside the IC through the metallization stack 20, the bond pads 52, 62 may be omitted in an alternative embodiment.

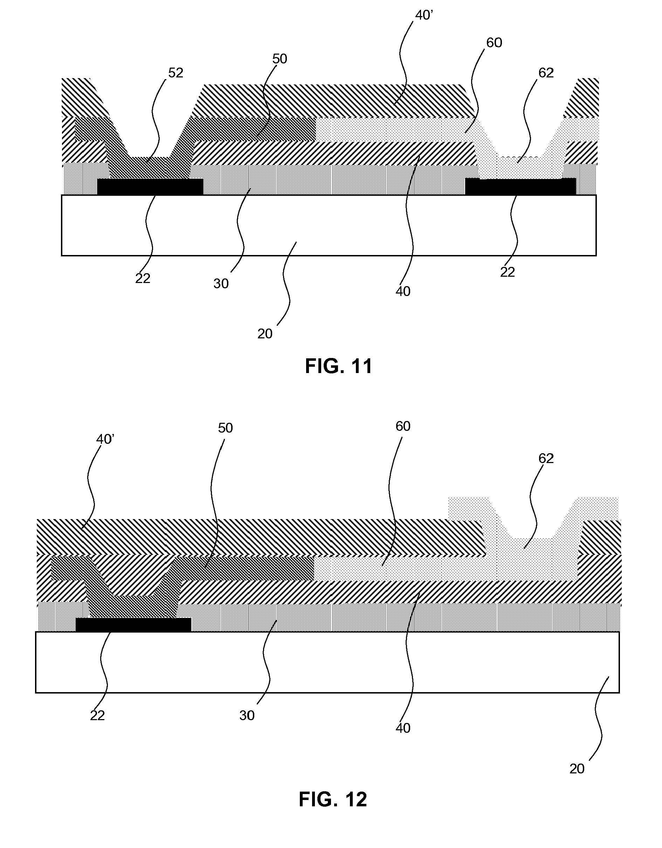

Similar to the various stacked capacitor embodiments of the moisture sensor shown in FIG. 6-8, the in-plane moisture sensor formed by interdigitated electrodes 52 and 62 laterally separated by a moisture-absorbing re-passivation layer 40 such as a polyimide layer, may alternatively be formed in a cross-over between the re-passivation and redistribution layers as shown in FIG. 11. As previously explained, the additional redistribution layer 40' albeit not used to redistribute IC contacts, provides additional passivation and stress-reduction, thereby improving the robustness of the IC.

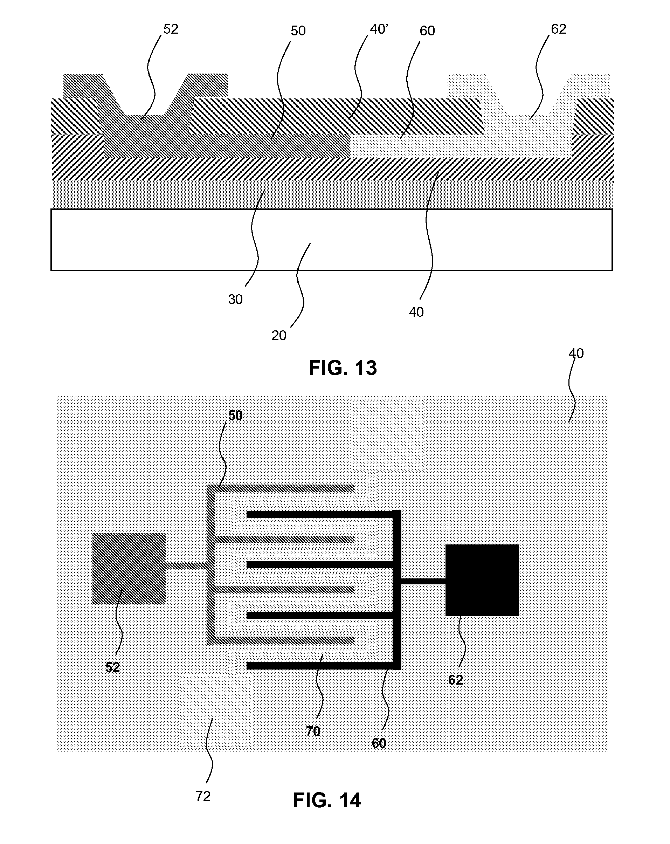

The interdigitated electrodes 50 and 60 may be connected to active circuitry of the IC or to external contacts. FIG. 12 shows an embodiment in which the redistribution layer 40' is used to provide an external connection of the second finger electrode 60 through bond pad 62 whilst the first finger electrode 50 is connected to active circuitry inside the IC through the metal portion 22 exposed in the passivation layer 30 and the underlying metallization stack 20. FIG. 13 shows an alternative embodiment in which both finger electrodes 50 and 60 can be externally connected through respective bond pads 52 and 62. This has the advantage that the passivation layer 30 underneath the electrodes 50 and 60 does not need to be opened, thereby reducing the risk of moisture penetrating the metallization stack 20 of the IC, especially when only the moisture sensor formed by the electrodes 50 and 60 and the re-passivation material in between these electrodes is exposed to the environment, as will be explained in more detail later.

Further modifications will be apparent to the skilled person. One such modification is shown by way of non-limiting example in FIG. 14, which depicts a top view of an IC according to another embodiment of the present invention, in which the moisture sensor comprises a third meandering electrode 70 connected to bond pads 72 to form a meander-comb serpentine capacitor. Such capacitors are known per se. An advantage of a serpentine capacitor is that the meandering electrode 70 can be used for resistance measurements to ensure that there are no defects such as shorts or opens in the sensor design.

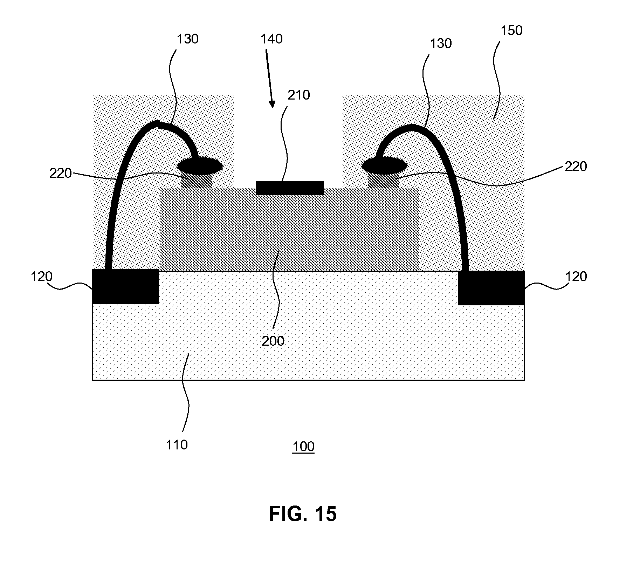

FIG. 15 depicts an IC package 100 according to an embodiment of the present invention. The IC package 100 comprises a carrier 110 such as a PCB carrying an IC 200 according to the present invention, which includes a moisture sensor 210, e.g. a relative humidity sensor, according to any of the aforementioned embodiments. The bond pads 220 are connected to the PCB contacts 120 in any suitable manner, e.g. through wire bonding 130. the package 100 contains a cavity 140 to expose the moisture sensor 210 to the external environment. The dimensions, e.g. width, of the cavity 140 may be chosen such that only the sensor 210 is exposed in the cavity, with the remainder of the IC 200 protected by the molding 150, which for instance may be an epoxy resin or any other suitable resin for packaging an IC. This has the advantage that the risk of the metallization stack 20 being penetrated by moisture through the passivation layer 30 is minimized.

It should be noted that the above-mentioned embodiments illustrate rather than limit the invention, and that those skilled in the art will be able to design many alternative embodiments without departing from the scope of the appended claims. In the claims, any reference signs placed between parentheses shall not be construed as limiting the claim. The word "comprising" does not exclude the presence of elements or steps other than those listed in a claim. The word "a" or "an" preceding an element does not exclude the presence of a plurality of such elements. The invention can be implemented by means of hardware comprising several distinct elements. In the device claim enumerating several means, several of these means can be embodied by one and the same item of hardware. The mere fact that certain measures are recited in mutually different dependent claims does not indicate that a combination of these measures cannot be used to advantage.

## Claims

1. An integrated circuit (200) comprising a substrate (10) including a plurality of circuit elements and a metallization stack (20) covering said substrate for providing interconnections between the circuit elements, wherein the top of said stack is protected by a passivation layer stack (30), the integrated circuit further comprising a moisture sensor (210) comprising a first electrode (50) and a second electrode (60) separated from the first electrode by an electrically insulating moisture-absorbing material (40), wherein at least one of said first electrode and second electrode is located above the passivation layer stack.

2. The integrated circuit (200) of claim 1, wherein said moisture-absorbing material (40) forms at least a part of a re-passivation layer or a re-distribution layer over the passivation layer stack (30).

3. The integrated circuit (200) of claim 1 or 2, wherein the moisture-absorbing material (40) is a polymer material capable of forming hydrogen bonds with water.

4. The integrated circuit (200) of any of claims 1-3, wherein the moisture-absorbing material (40) is polyimide.

5. The integrated circuit (200) of any of claims 2-4, wherein the first electrode (50) and the second electrode (60) are meandering electrodes arranged relative to each other in an interdigitated fashion.

6. The integrated circuit (200) of any of claims 1-5, wherein at least one of the first electrode (50) and the second electrode (60) is electrically connected to an externally accessible bond pad (52, 62).

7. The integrated circuit (200) of any of claims 1-5, wherein at least one of the first electrode (50) and the second electrode (60) is electrically connected to at least one of said circuit elements.

8. The integrated circuit (200) of any of claims 1-7, wherein the top layer of the passivation stack (30) comprises silicon nitride (Si₃N₄).

9. The integrated circuit (200) of any of claims 1-8, wherein the second electrode (50) is covered by at least a part of the thickness of a redistribution layer (40').

10. An integrated circuit package (100) comprising the integrated circuit (200) of any of claims 1-9, wherein the package comprises a cavity (140) exposing the moisture sensor (210).

11. The integrated circuit package (100) of claim 10, wherein said cavity (140) is formed through a molded cover layer (150) of the package.

12. An electronic device comprising the integrated circuit package (100) of claim 10 or 11.

13. A method of manufacturing an integrated circuit (200), comprising:
providing a substrate (10) comprising a plurality of circuit elements on said substrate and a metallization stack (20) covering said substrate for providing interconnections between the circuit elements;
depositing a passivation layer stack (30) of said metallization stack;
forming a moisture sensor (210) over said passivation layer stack by:
providing a first electrode (50);
providing a second electrode (60); and
depositing an electrically insulating moisture-absorbing material (40) such that the first electrode and the second electrode are separated by the electrically insulating moisture-absorbing material.

14. The method of claim 13, wherein the step of depositing the electrically insulating moisture-absorbing material (40) is comprised in a step of depositing a re-passivation or a re-distribution layer over the passivation layer stack (30).

15. The method of claim 13 or 14, wherein:
the step of providing the first electrode (50) comprises forming a first meandering electrode on the electrically insulating moisture-absorbing material (40),
the step of forming the second electrode (60) comprises forming a second meandering electrode on the electrically insulating moisture-absorbing material, said second meandering electrode being spatially separated from the first meandering electrode and being arranged respective to the first meandering electrode in an interdigitated manner; and
wherein the method further comprises filling the gap between the first meandering electrode and the second meandering electrode with the electrically insulating moisture-absorbing material.
